# EUROPEAN PATENT APPLICATION

(11) **EP 1 411 205 A2**
(43) Date of publication of application: **21.04.2004**
(21) Application number: 03256410.6
(22) Date of filing: 10.10.2003
(51) Int. Cl.: E06B 9/32, H02M 7/06

(54) **Power conversion unit and method of providing power to a window covering**

(30) Priority: 17.10.2002 EP 02257217
(71) Applicant: HUNTER DOUGLAS INDUSTRIES B.V., 3008 AB Rotterdam (NL)
(72) Inventor: Osinga, Anne J., D, 3235 AC Rockanje (NL)
(74) Representative: Smith, Samuel Leonard

(57) **Abstract**

A power conversion unit and a method of providing power to a powered movable window covering using a conversion circuitry with a transformer to obtain relatively low voltage supply from main supply, the method including (a) providing in the conversion circuitry a snubber circuit for the transformer, the snubber circuit absorbing power from the transformer and supplying power absorbed from the transformer back to the conversion circuitry such that heat generation from the conversion circuitry with the transformer is minimised and (b) mounting the conversion circuitry in the headrail of the window covering so as to reduce the overall size of the window covering.

## Description

The present invention relates to a power conversion unit for a window covering, in particular a powered movable window covering, and a method of providing power to such a window covering.

Various types of window covering are well known and include, for instance, Venetian blinds, roller blinds, vertical-slat blinds, pleated and cellular shades. These coverings have well known uses for selectively covering not only windows, but any other form of architectural opening.

Window coverings usually include a headrail for supporting or at least controlling the covering or blind itself. EP-A-1020613 considers such a headrail. It will be appreciated that headrails are usually positioned above the blind with a horizontal orientation. However, headrails may also be used in other orientations, such as a vertical orientation.

Traditionally, headrails are provided with pull cords and/or rotatable wands for operating the covering. In particular, the headrails incorporate mechanisms whereby movement of the cords or wands causes a corresponding movement of the covering.

It is also known to provide a powered window covering whereby powered actuators such as motors provide the moving forces previously required from the cords or wands. While these powered window coverings are very effective and desirable, the additional actuators (such as motors) and associated power supplies require extra space and result in the overall arrangement being undesirably bulky.

The present application is particularly concerned with the power supply and recognises for the first time the possibility of incorporating a power conversion unit within the headrail of a window covering in order to reduce the overall size of the assembly.

Based on this recognition, it is an object of the present invention to miniaturize the transformer required for power conversion such that it can be mounted within a headrail. However, as is well known, all transformers, in particular, high frequency transformers, fall short of their theoretical ideal. As a result, for instance, of magnetic field leakage, voltage spikes can occur which are traditionally handled by resistive snubber circuits. The snubber circuits and transformers generate undesirable amounts of heat which prevent such a power conversion unit from being installed within a headrail.

It is an object of the present invention to overcome or at least reduce these problems.

According to the present invention, there is provided a method of providing power to a powered movable window covering using conversion circuitry with a transformer to obtain relatively low voltage supply from mains supply, the method including a) providing in the conversion circuitry a snubber circuit for the transformer, the snubber circuitry absorbing power from the transformer and supplying power absorbed from the transformer back to the conversion circuitry such that heat generation from the conversion circuit with the transformer is minimised and b) mounting the conversion circuitry in the headrail of the window covering so as to reduce the overall size of the window covering.

Thus, similarly, according to the present invention there is also provided a power conversion unit for a powered movable window covering, the unit including power conversion circuitry having a transformer, a snubber circuit for absorbing power from the transformer and a housing containing the power conversion circuitry and snubber circuit, wherein the snubber circuit provides power absorbed from the transformer to the power conversion circuitry.

In this way, the overall heat generation of the power conversion unit is significantly reduced such that it does become possible to provide the power conversion unit in the confined space of a headrail. Suitable snubber circuits, incorporating for instance, capacitive measures for absorbing and then releasing the power from the transformer, are known for other transformer applications. Many of these snubber circuits may be adapted for use with the present invention. However, according to the preferred embodiment the snubber circuit provides absorbed power to the primary side of the transformer.

It will be appreciated that transformers are often constructed with an additional secondary coil which is used to provide power to components on the primary side. By using the snubber circuit to provide this power, this additional secondary coil can be eliminated and the overall construction simplified and reduced in size. Furthermore, with power provided from the snubber circuit to the primary side, there is no connection from the high voltage primary side to the low voltage secondary side, thereby enhancing safety.

Preferably the transformer includes high frequency ferrite transformer cores.

Thus, the method may include supplying the transformer with high frequency AC power.

In this way, in comparison to using a transformer at a normal mains frequency of 50 Hz to 60 Hz, it is possible to substantially reduce the overall size of the transformer. In particular, high frequency ferrite cores can be of significantly reduced size for the same power/voltage transformation.

Preferably, the power conversion circuitry includes a rectifier for converting mains power to DC power and an inverter for converting the DC power to high frequency AC power for supply to the transformer.

In this way, the power conversion unit may be connected to a normal mains supply and yet still use high frequency ferrite transformer cores to provide a low voltage supply for any control circuitry and actuators in the window covering. By using the high frequency ferrite transformer cores of reduced dimensions in conjunction with the snubber circuit for providing power from the transformer back to the power conversion circuitry, it is possible to provide a power conversion unit of significantly reduced dimensions and heat generation.

Preferably, the high frequency is over 100 KHz. This allows the use of suitable cores. Indeed, for lower frequencies, undesirably large induction coils are required as filters.

It would be desirable to provide a frequency which is as high as possible. However, 300 KHz is the approximate practical upper limit. As the frequency is increased, so the size of the induction coils for filtering can be reduced. However, at higher frequencies, it becomes necessary to incorporate additional, more elaborate, circuitry, such that the overall size again starts to increase.

Preferably, the inverter converts the DC power to high frequency AC power with a fluctuating frequency.

This results in electromagnetic emissions which have a spread spectrum rather than a high peak point. As a result, the overall effect of emissions is reduced together with any noise production of the power supply. Preferably, the frequency fluctuates between 250 KHz and 300 KHz.

This range is sufficient to give a good spread spectrum and is positioned at a high frequency to allow the reduction in size of the ferrite cores.

Preferably, the housing has a cross section suitable for insertion into a headrail of a window covering.

Hence, the power conversion unit may be used to meet the objective of the present invention.

Preferably, the housing is elongated in a direction substantially perpendicular to the cross section.

In this way, for a headrail of relatively small cross section, it is still possible to insert the power conversion unit by arranging the components of the power conversion unit in an elongate fashion.

In particular, preferably, the power conversion circuitry includes first and second circuit boards extending in the elongate direction, the first circuit board supporting at least the transformer and the second circuit board supporting at least other components of the power conversion circuitry.

Preferably, the transformer is divided into a plurality of serially connected sub-transformers arranged along the first circuit board in an array in the elongate direction.

This is particularly advantageous in allowing the dimensions of the transformer to be reduced still further in at least two dimensions. The transformer is extended by means of the sub-transformers, along the third dimension in the elongate direction. This allows the transformer to be inserted in a headrail of small cross section.

Preferably, large components, such as capacitors, are supported at one or both ends of the first and circuit boards and extend generally in the elongate direction.

In this way, to minimise the cross section required by the power conversion unit, the large components are mounted so as to encompass an extension of the cross section of the circuit boards rather than to add to that cross section by being mounted on one side.

In one embodiment, the first and second boards may be joined end to end so as to form a single elongate circuit board.

The power conversion unit of the present invention may be used with a headrail having a rotatable shaft extending along the headrail at a generally central position. With this embodiment, the housing preferably has a cross section suitable for insertion into the headrail on generally one side of the rotatable shaft. All of the components of the power conversion unit extend along one side of the rotatable shaft.

According to another embodiment, the first and second circuit boards preferably extend in generally parallel spaced apart planes so as to define at least a central space therebetween.

The housing preferably has openings at each end in line with the central space such that the housing can be inserted in the headrail with the rotatable shaft of the headrail extending through the central space.

Thus, in this way, the components associated with the first circuit board extend on one side of the shaft and the components associated with the second circuit board extend along the other side of the shaft. Of course it will also be possible for components to extend into the space between the first and second circuit boards either side of the central space occupied by the rotatable shaft.

Preferably, the housing includes end caps at each end, the end caps defining the openings.

The housing preferably also includes an inner wall defining an elongate central passageway extending through the housing in the central space, the passageway allowing the shaft to be located extending through the housing.

The inner wall prevents the interference between the components of the power conversion unit and the rotatable shaft.

According to the present invention, there is also provided a headrail for a window covering including the power conversion unit.

Preferably the headrail includes the rotatable shaft extending generally centrally along its length. The shaft may be used for retracting/deploying a covering and/or tilting slats on the covering.

The power conversion unit may also be mounted outside the headrail and still provide significant advantages. In particular it allows the overall assembly to be of reduced size and can be mounted in small spaces adjacent to the headrail.

According to the present invention, there is also provided a window covering assembly including the headrail.

The invention will be more clearly understood from the following description, given by way of example only, with reference to the accompanying drawings, in which:
Figure 1 illustrates a perspective view of a power conversion unit according to the present invention;
Figure 2 illustrates an exploded view of the power conversion unit of Figure 1;
Figure 3 illustrates a perspective view of the power conversion unit of Figure 1 with end portions of the housing broken away;
Figure 4 illustrates a lower plan view of the circuit board of the embodiment of Figure 3;
Figure 5 illustrates a perspective view of the embodiment of Figure 2 with the power conversion circuitry extended from one end of the housing;
Figure 6 illustrates a top plan view of the printed circuit board of Figure 4;
Figure 7 illustrates a circuit diagram of the input circuit connected to the primary side of the transformer;
Figure 8 illustrates a circuit diagram of the output circuit connected to the secondary side of the transformer;
Figure 9A illustrates a circuit diagram of a local voltage controlled oscillator for controlling the circuit diagram of Figure 7;
Figures 9B, 9C and 9D illustrate various voltages within the circuit of Figure 9A;
Figure 10 illustrates a control circuit for use with the circuit of Figure 7 for eliminating the effects of load or input variations;
Figure 11 illustrates a circuit diagram for a snubber providing an auxiliary power supply;

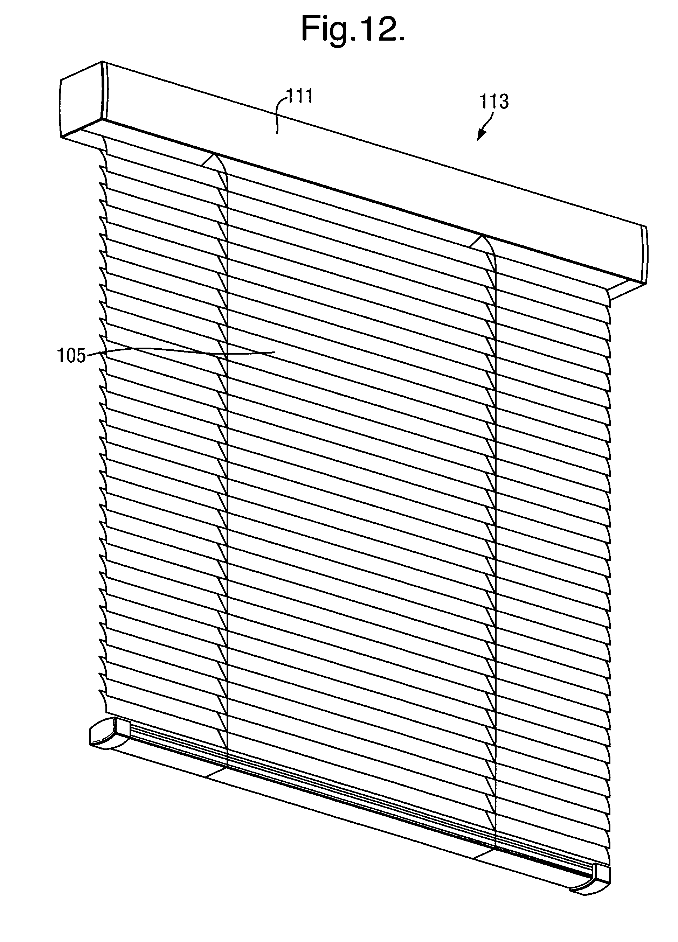

Figure 12 illustrates a window covering arrangement in which the present invention may be embodied;
Figure 13 illustrates an end view of a headrail incorporating the power conversion unit of Figure 1;
Figure 14 illustrates an end view of a headrail with two alternative positions for supporting the power conversion unit of Figure 1, one inside and one outside of the headrail;
Figure 15 illustrates an end view of a headrail supporting the power conversion unit of Figure 1 on the rear side of the headrail;
Figure 16 illustrates a roller blind headrail supporting the power conversion unit of Figure 1;
Figure 17 illustrates an end view of a headrail, such as for a pleated or cellular shade, incorporating the power conversion unit of Figure 1;
Figure 18 illustrates in an exploded arrangement an alternative power conversion unit embodying the present invention; and
Figure 19 illustrates the power conversion unit of Figure 18 partially fitted in a headrail.

The following description relates to two principal embodiments, the first of which is intended to fit within approximately half the cross section of a headrail on one side of a rotatable shaft and the second of which is intended to approximately fill the cross section of a headrail and is provided with a central space for accommodating the shaft. The electronic components making up the power conversion circuitry may be the same in each embodiment and are described with reference to the first embodiment.

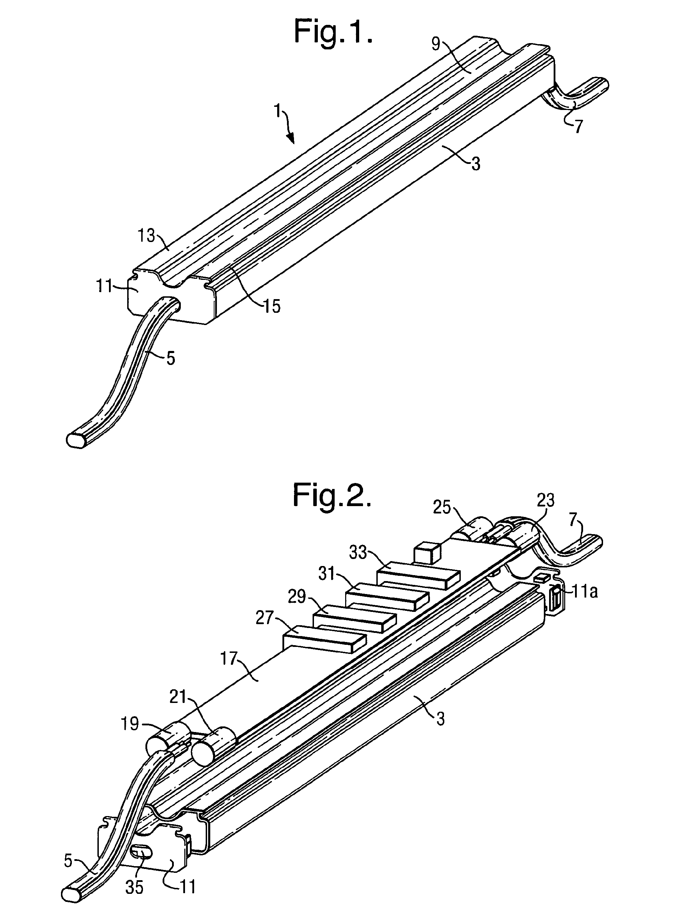

Figure 1 illustrates an assembled power conversion unit 1 according to the first embodiment. The unit includes a housing 3 with an input lead 5 and an output lead 7. The housing 3 preferably has a constant cross section along its elongate length, with the respective input and output leads extending from opposite longitudinal lengths.

The elongate housing 3 is provided with a generally semi-circular recessed groove 9 which, as will be described below, provides clearance for a longitudinally arranged shaft. Preferably, the longitudinal ends are closed off with end caps of which only end cap 11 is visible in Figure 1. The illustrated housing 3 is also provided with longitudinal ridges 13 and 15 along opposite sides of the housing. These ridges may be used for mounting the housing.

Figure 2 illustrates the housing 3 with its two end caps 11, 11a detached and the power conversion circuitry moved. In particular, the circuit board 17 is illustrated at a position above the housing 3.

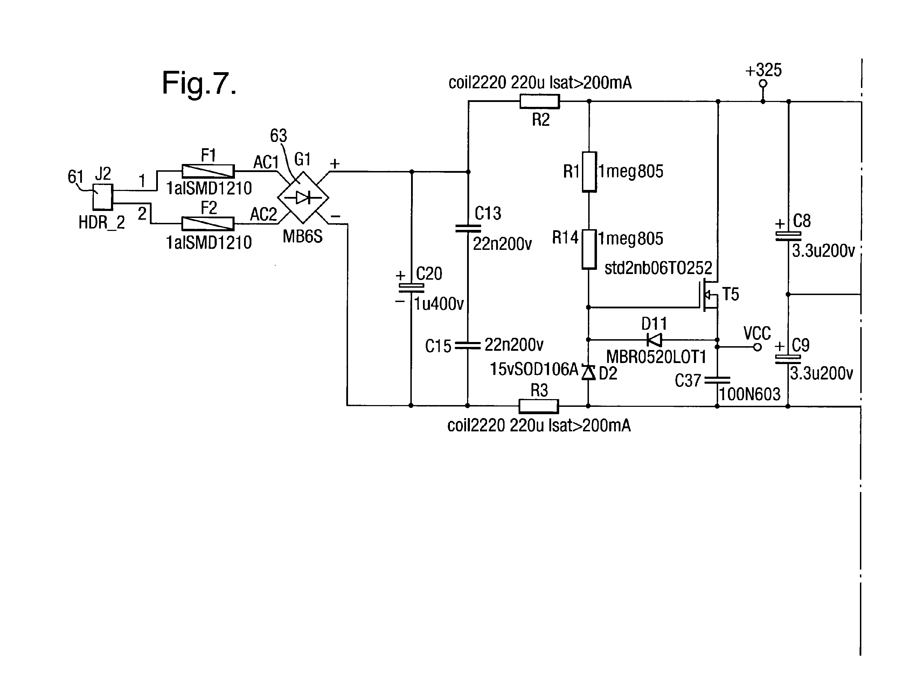

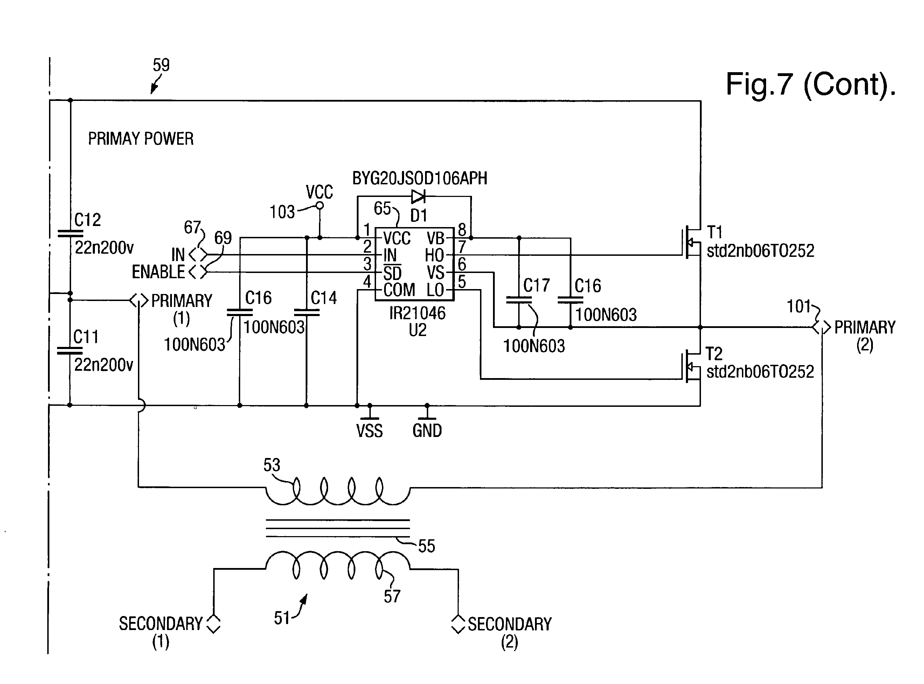

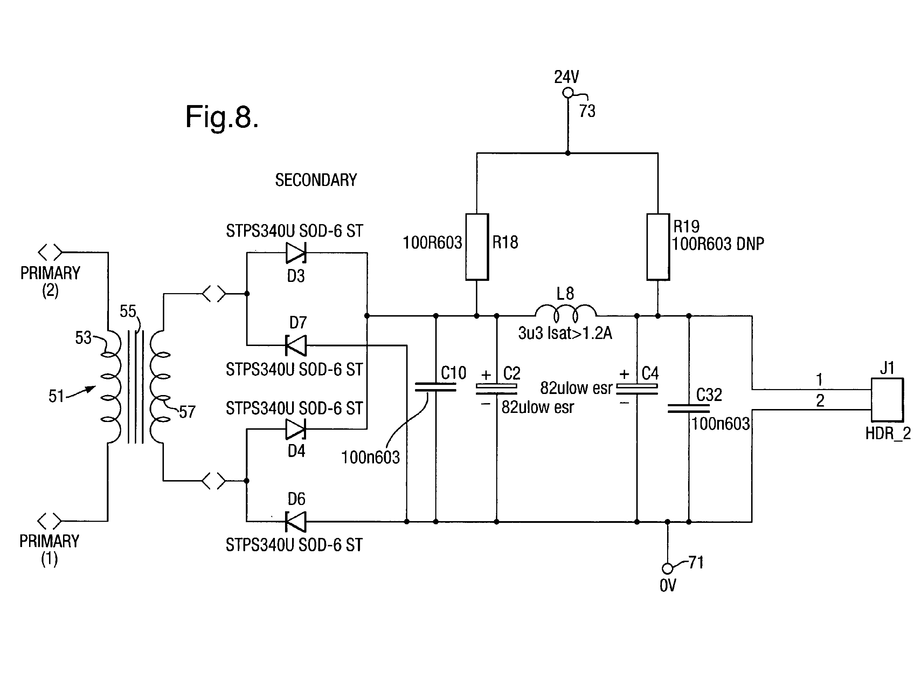

The circuit board 17 has components of the power conversion circuitry arranged on it so as to make more use of the space within the housing 3. For example, components of large size, such as condensers/capacitors 19,21,23,25 are positioned at the end of the circuit board 17 to take maximum advantage of the available space within the housing 3. These components are arranged so as to extend generally along the plane of the circuit board 17. They extend at least partly within an extended volume of the circuit board 17 and hence avoid extending to one side of the circuit board 17 by an unnecessary amount. It is particularly advantageous to position there the primary and secondary capacitors/elcos C8,C9,C20 and C2,C4 respectively of Figures 7 and 8, to be described further below.

The circuit board 17 is also arranged with the power conversion transformer divided into a number of serially connected sub-transformers, each having cores 27,29,31,33 of relatively reduced size.

Other electrical components on the circuit board 17 may be kept within the boundaries of a cross section defined by the condensers 19-25 and transformer cores 27-23. For convenience, therefore, these components are not noted particularly in Figure 2.

The resulting arrangement of components on the circuit board 17 has an elongate length and a cross section of low profile. This allows it to be fitted within the elongate profile housing 3 illustrated in Figures 1 and 2. End cap 11 is provided with an aperture 35 to guide the input lead 5 outside of the housing 3. A similar aperture is provided in end cap 11a on the opposite longitudinal end of housing 3 so as to lead the output lead 7 outside of the housing 3.

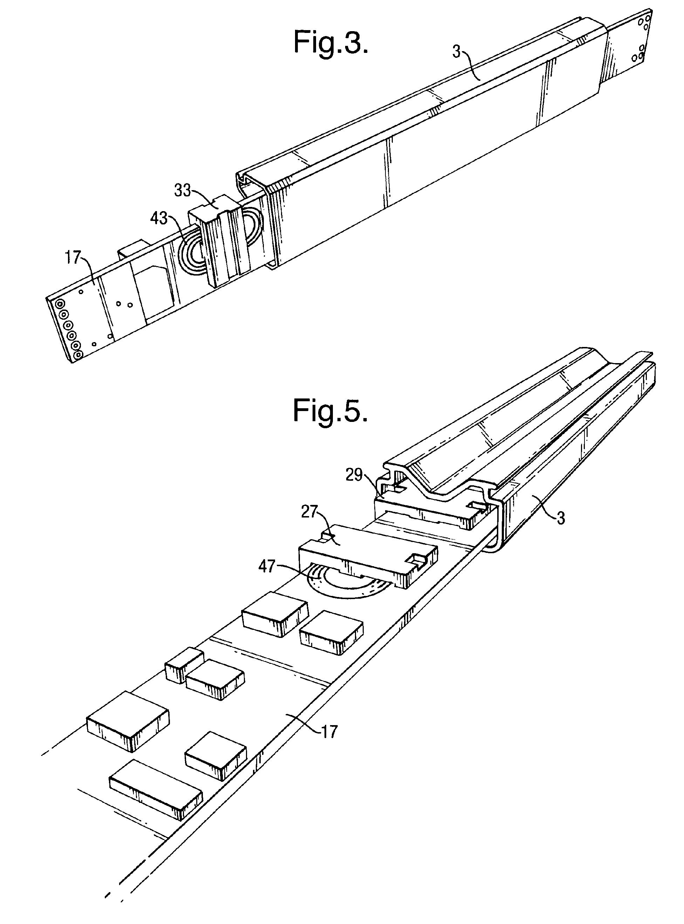

Figure 3 shows a bottom perspective view of a power conversion unit with end sections of the housing 3 removed so as to expose the circuit board 17. It should be noted how the contours of the transformer core 33 fit snugly within the contours of the interior of the housing 3. Figure 5 illustrates a similar perspective view from the top of housing 3 showing the circuit board 17 only partially inserted into the housing 3.

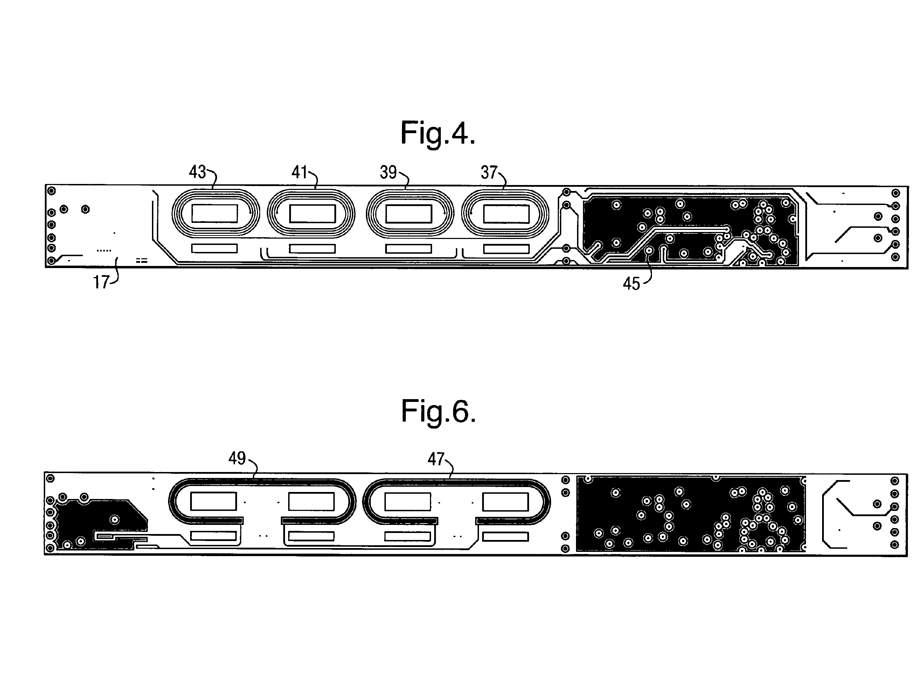

Figures 4 and 6 illustrate respectively the bottom side and top side of a circuit board 17 without the housing 3 discussed above. In this embodiment, the circuit board 17 is a single elongate structure. However, according to alternative embodiments to be mentioned below, the circuit board 17 could be divided in two and provided as first and second elongate circuit boards.

On the bottom side of the circuit board 17 illustrated in figure 4, a circuit layout is imprinted for the primary circuit. Primary windings 37, 39, 41, 43 are provided for each of the transformer cores 27, 29, 31, 33. In this respect primary winding 43 is visible under transformer core 33 in Figure 3. At the other end of the circuit board 17, a section 45 is provided for carrying other components of the power conversion circuitry, for instance a rectifier, inverter and snubber circuit to be discussed below.

Figure 6 shows the top side of circuit board 17. On one end of the elongate circuit board, there is imprinted the combined secondary windings 47,49 of the core pairs 27,29 and 31,33 respectively. In this respect, secondary winding 47 and core pairs 27,29 are illustrated in Figure 5. The other end of the circuit board 17, as discussed for the bottom side with relation to Figure 4, has a section for carrying other components of the power conversion circuitry.

The following description relates to a preferred arrangement for the power conversion circuitry. It will be appreciated that a substantial number of variations may be made to this circuitry without departing from the scope of the invention. Indeed, parts of the power conversion circuitry have well known functions which can be replaced by equivalent alternative circuitry.

Figure 7 illustrates a third input circuit 59 including a transformer 51. The transformer 51 has at least one primary winding, schematically represented by numeral 53, at least one core, schematically represented by numeral 55, and a secondary winding, schematically represented by numeral 57. As will be explained below, the core 55 is preferably a high frequency ferrite core and the transformer 51 is used to transform AC power at high frequencies, for instance 250KHz to 300 KHz. The transformer 51 may be embodied as discussed above with reference to Figures 1 to 6, as a plurality of serially connected transformers, each having a reduced sized core 27, 29, 31 and 33. The cores are preferably constructed of a ferrite material having a high saturation flux density, high Curie temperature and low dissipation losses. High frequency ferrite core transformers of this type allow significant reduction in overall size and provision of the transformer(s) within the relatively confined housing 3.

The input circuit 59 is intended to receive, from an input header 61, mains power supply, such as conventional 220/240 volt or 110 volt alternating at 50 Hz or 60 Hz.

The input power passes through a bridge rectifier 63 to convert the alternating power supply into a DC power supply. A preferred rectifier for use as rectifier 63 is the Fairchild P/N MB6S 0.5A bridge rectifier. Capacitors C20, C13 and C15 receive and smooth the power and then a half-bridge driver 65 cycles transistors T1 and T2 on and off in order to convert the DC power provided by the capacitors C20, C13 and C15 into a high frequency power supply for the primary winding(s) of the transformer 51. In the preferred embodiment, this AC power supply alternates with a frequency in the order of 250 KHz to 300 KHz.

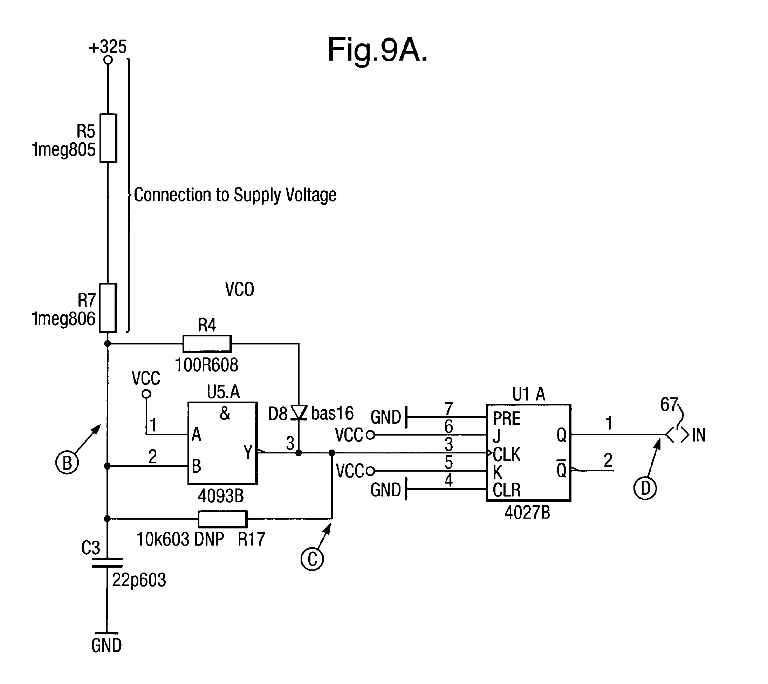

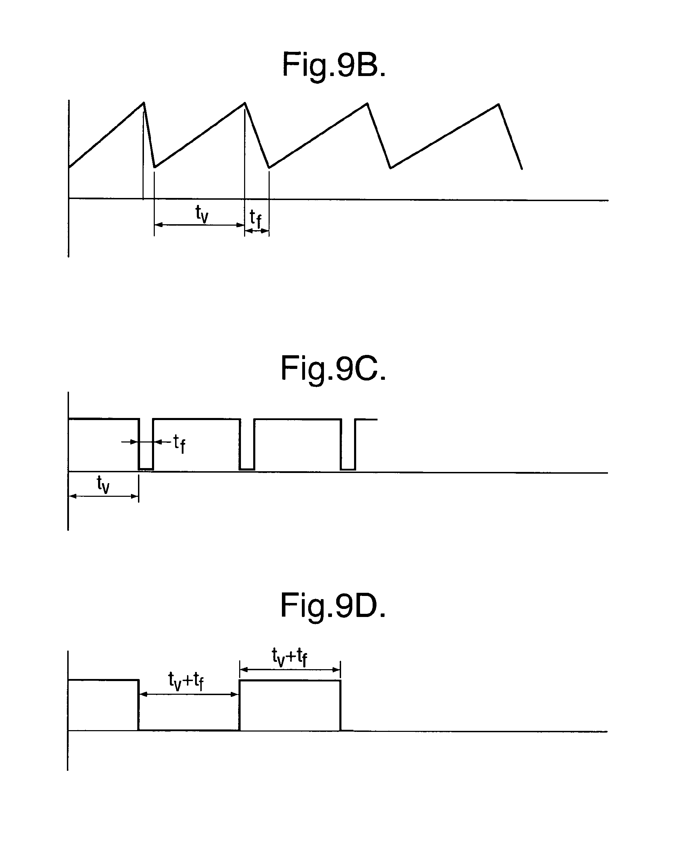

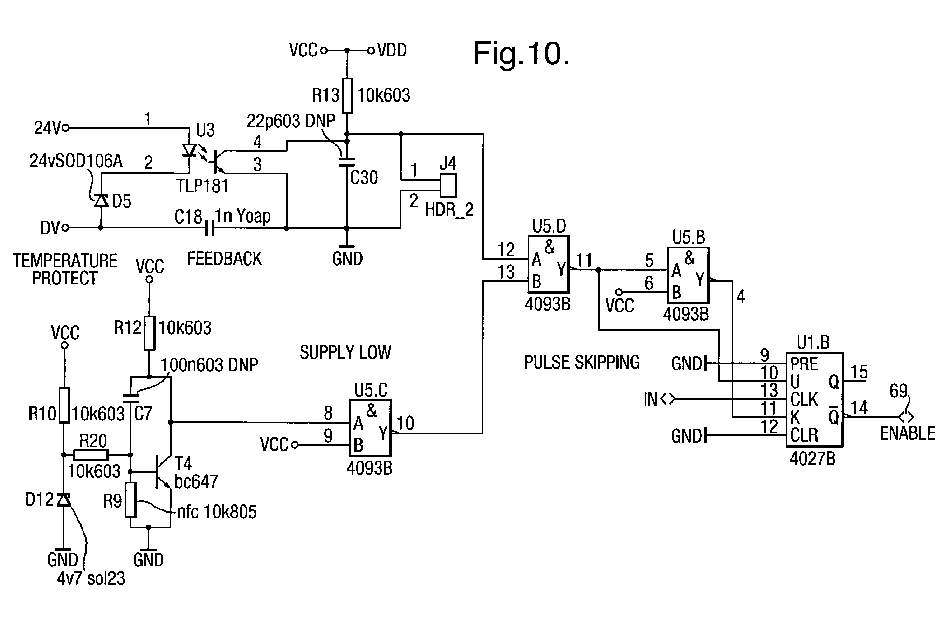

The half-bridge driver 65 is preferably embodied as an IR2104 (S) type of an International Rectifier. In this arrangement, a first port 57, labelled "IN", and a second port 69, labelled "ENABLE", are provided. These ports will be referred to below in relation to Figures 9 and 10 respectively.

Figure 8 illustrates the secondary side of the power conversion circuitry of the preferred embodiment. The high frequency transformed power induced in the secondary windings 57 is provided to a bridge arrangement of diodes, D1, D4, D6 and D7. The bridge converts the transformed alternating power into a DC signal. Which converts the transformed alternating power into a DC signal. In the preferred embodiment, the diodes are preferably power Schottky rectifiers, for instance those having SMD code U34 as manufactured by ST Microelectronic of Veldhoven.

An array of elcos C2 and C4, together with parallel capacitors C10 and C32 and inductor L8 further stabilise the output from the bridge rectifier from diodes D3 to D7. A low voltage DC supply of 24 volts is thus available between terminals 71 and 73.

In order to reduce electromagnetic emissions from the transformer 51, it is proposed that the actual frequency at which the transformer 51 operates is fluctuated in a controlled manner. In this way, the power of any emissions from the transformer 51 is spread over a predetermined spectrum and the power for any particular frequency is significantly reduced when compared to operating the transformer only at that frequency. This has significant advantages with regard to reducing noise.

Figure 9A illustrates a preferred arrangement for achieving the required fluctuation in frequency. It includes a local voltage controlled oscillator which provides a signal to the first port 67 of the half-bridge driver of 65 of Figure 7. This signal controls the half-bridge driver 65 such that the inverter formed in the circuit 59 of Figure 7 produces an AC signal in the primary winding 53 which fluctuates in frequency. In the preferred embodiment, the local oscillator of Figure 9A causes the frequency to fluctuate between 250 KHz and 300 KHz.

Figures 9B, 9C and 9D illustrate voltages at points B, C and D as marked in Figure 9A.

Period tᵥ is determined by the supply voltage (provided through resistors R5 and R7, the +325V supply charges capacitor C3), whereas the period t_{f} is a fixed value (the discharge through R4, D8, R5 and R7 is negligible). Hence, tᵥ is variable whereas t_{f} is not.

U1.A functions as a divider (in half) such that a frequency results which has a period or duration of 2tᵥ +2t_{f}. The frequency thereby depends on the supply voltage.

When the supply is loaded, the supply voltage will fluctuate with the result of a fluctuating frequency.

Figure 10 provides a signal to the enable port 69 of the half-bridge driver 65. This circuit is a control circuit for keeping the output voltage at a fixed level and for eliminating mode or input variations.

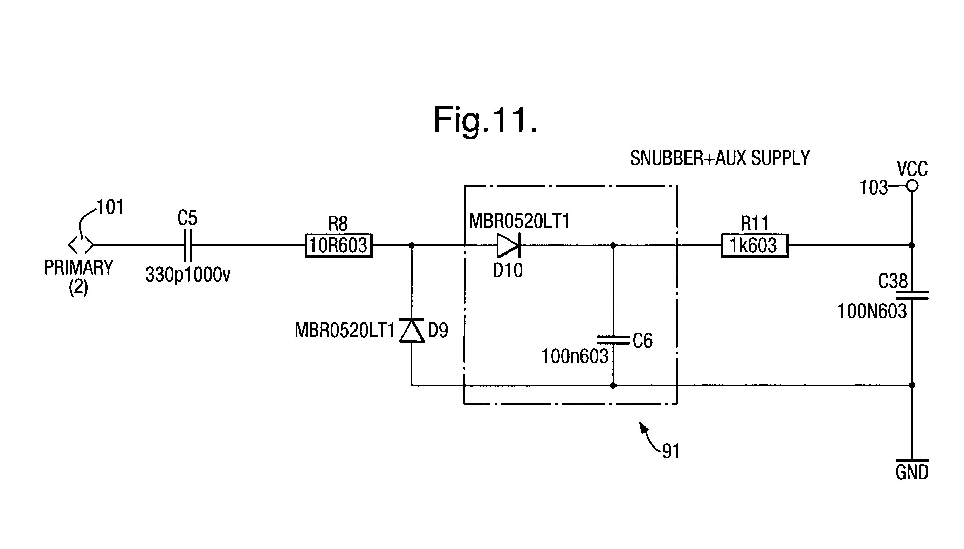

A significant feature of the present invention is the provision of a snubber circuit which absorbs unwanted power from the transformer 51, but does not merely dissipate this power as resistive losses. Instead, the power is fed back to the power conversion circuitry. Figure 11 illustrates the preferred arrangement for the snubber circuit. However, although this circuit is believed to have significant advantages in its application in the power conversion circuitry of the present invention, it should be appreciated that other snubber circuits could also be used.

A number of known dissipitive snubber circuits have been considered in a number of previous publications, such as US 4,438485, US 4,899270, US 5, 548,503, US 5,615094 and US 6,285,567 B1 and the teachings of these documents are incorporated by reference.

It will be appreciated from these documents that a number of imperfections in any practical implementation of a transformer will result in undesirable outputs from the transformer, for instance in the nature of voltage spikes. By way of example, inevitably there will be some leakage flux from the primary side of the transformer and collapse of this flux will cause undesirable voltage spikes. Snubber circuits have been provided to absorb this excess energy, but, traditionally these snubber circuits have dissipated the power into resistive loads. This resistive dissipation produces undesirable amounts of heat, thereby preventing the transformer from being installed within the headrail of a window covering.

The power conversion circuitry of the present invention allows a power conversion unit to be installed in the headrail of a window covering by using a snubber circuit which provides the absorbed power back into the conversion circuitry itself.

As illustrated, the snubber circuit of Figure 11 is connected at 101 to the primary winding 53 of the transformer 51. The snubber circuit 91 then absorbs any excess energy in the form of voltage peaks and provides this back to the power supply VCC labelled as 103 in Figures 7 and 11.

By means of the arrangement discussed above, it is possible to incorporate all of the components of the power conversion circuitry into a compact housing 3 as illustrated in Figure 1.

The housing 3 may be installed in the headrail 111 of a window covering arrangement 113. The headrail 111 can take a variety of forms. However, many headrails incorporate a rotatable shaft which is mounted centrally along the length of the headrail. Rotation of this shaft may be used to deploy or retract the covering 105 and/or, where the covering 105 includes slats, rotate those slats.

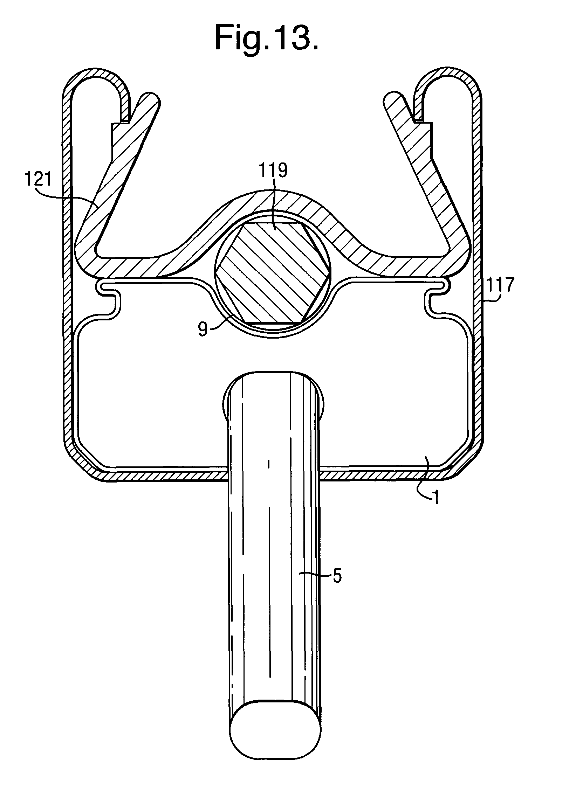

Figures 13 to 17 illustrate a housing 3 as installed in a variety of different headrails. In particular, these Figures illustrate cross sections through the headrails. In Figure 13 the power conversion unit is inserted in the lower portion of a headrail 117 and mates with the inner side and bottom surfaces of the headrail 117. As illustrated, the groove 9 provides a central space through which a rotatable shaft 119 may extend. An insert or clip 121 then keeps the power conversion unit to the lower side of the headrail 117.

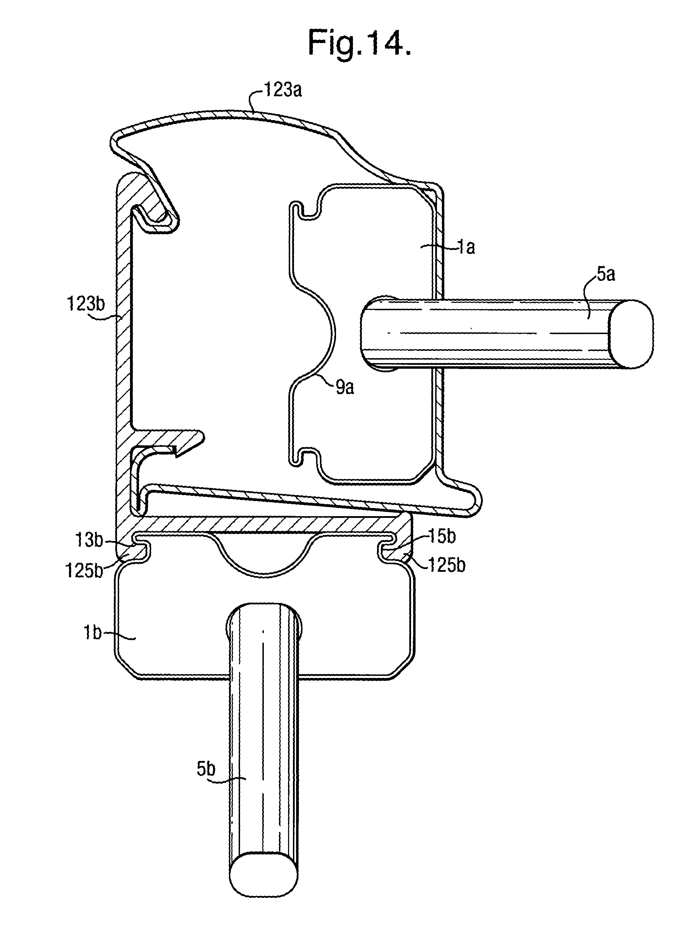

In Figure 14, two power units 1a and 1b are mounted to a headrail 123a, 123b. The first power conversion unit 1a is mounted within the headrail 123a, 123b towards the right side as illustrated in Figure 14 and the groove 9a leaves a central space for a rotatable shaft if required. The unit 1a may be held in place by a clip, not illustrated, but similar to that of Figure 13.

The second power conversion unit 1a is attached to a lower surface of the headrail 123a, 123b by means of ridges 13b and 15b discussed above with relation to Figure 1. In particular, the headrail 123a, 123b is provided on its lower surface with inwardly facing grooves 125b which slidingly engage in the the ridges 13b and 15b to secure the second power conversion unit 1b in place.

It will be appreciated that the headrail of this embodiment is composed of two parts, an upper part 123a and a lower part 123b. However, this is of no significant relevance to the present invention.

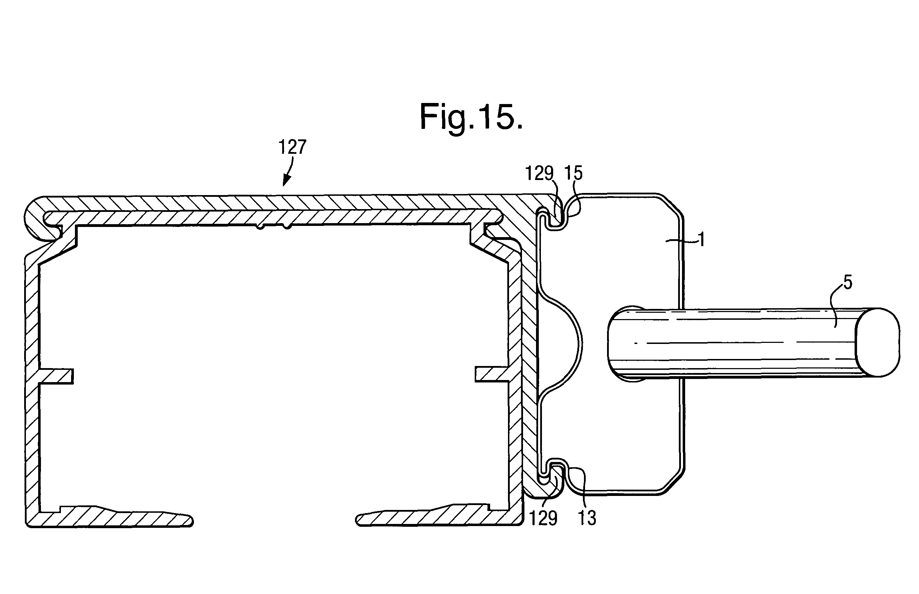

In the embodiment of Figure 15, the power conversion unit is attached to the side of a headrail 127 by means of its ridges 13 and 15. In the same way as described for Figure 14, inwardly facing grooves 129 slidingly engage in the ridges 13 and 15. In this arrangement, it will be appreciated that the power conversion unit is not installed within the headrail 127. Nevertheless, the small size of the power conversion unit 1 still reduces the overall size of the assembly. Indeed, it might be possible to install the power conversion unit 1 between the headrail 27 and a wall in situations in which this would otherwise not be possible. The low heat production by the power conversion circuitry still allows the power conversion unit to be installed in confined spaces.

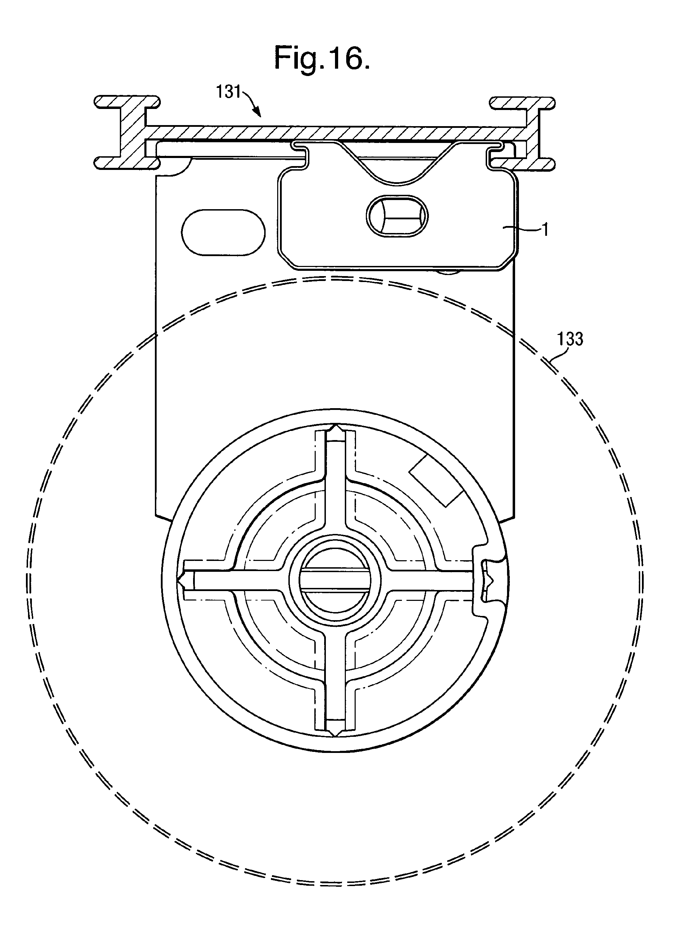

The embodiment of Figure 16 shows an alternative headrail 131 in conjunction with a roll 133 which may operate a window covering under power from the power conversion unit 1.

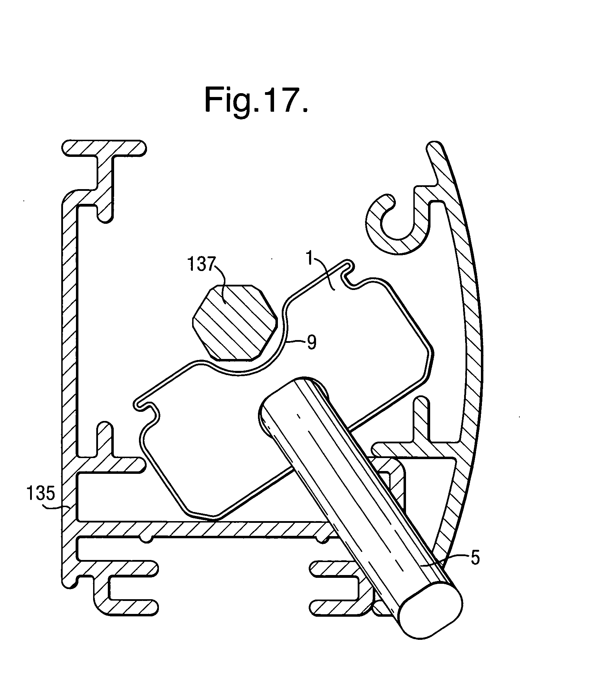

Figure 17 illustrates a headrail 135 in which the power conversion unit 1 is mounted with a slanted or diagonal orientation. In this embodiment, the groove 9 again provides a central space in which a shaft 137 may extend and rotate.

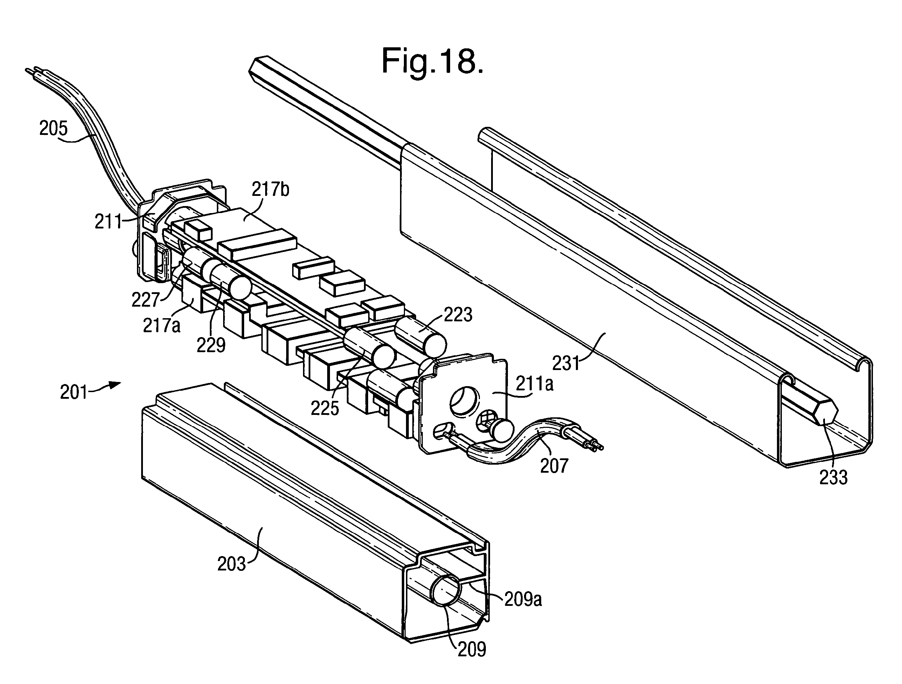

As mentioned above, it is also possible to divide the circuit boards 17 in two. Figure 18 illustrates an embodiment of this type.

A first circuit board 217a includes a primary and secondary windings and the transformer cores are arranged along its length. A second circuit board 217b is spaced apart from the first circuit board 217a and is orientated within a generally parallel plane. This circuit board can support other components of the power conversion circuitry, noting that some other components could also be mounted on the first circuit board 217a. As with the embodiments described above, in particular as shown in Figure 2, bulky components 223, 225 may be mounted on one or more ends of the circuit boards 217a, 217b. However, in addition, further bulky components 227, 229 may be mounted between the circuit boards.

With this arrangement, it is possible to provide an arrangement which has the same width as that of Figure 2, but at least half its length. Indeed, it is possible to reduce the length by more than half whilst retaining a square cross section by mounting components such as components 227 and 229 between the first and second circuit boards 217a, 217b.

The illustrated preferred embodiment is intended for use with a headrail 231 similar to that of Figure 13 having a central rotatable shaft 233. Therefore, for this embodiment, the first and second circuit boards are arranged with a central space therebetween. Indeed, where bulky components, such as 227 and 229 are mounted between the first and second circuit boards, these bulky components are arranged only along the sides either sides of a central space such that a shaft can pass between the first and second circuit boards along their length.

As illustrated, the housing 203 includes an inner wall 209 defining a central passageway extending the length of the housing 203. The central wall 209 is supported by wall 209a which extends between the inner wall 209 and at least one outer wall of the housing 203. The first and second circuit boards and any components attached to them may thus be fitted within the housing 203 outside the inner wall 209. The passageway within the wall 209 allows the shaft 233 to extend through the power conversion unit without interference with the circuit boards or components. In the preferred embodiment, end caps 211 and 211 a are provided on opposite ends of the housing 203. The end caps define openings though which the shaft 233 may extend into the passage within the inner wall 209. The input lead 205 and output lead 207 may also extend from respective end caps.

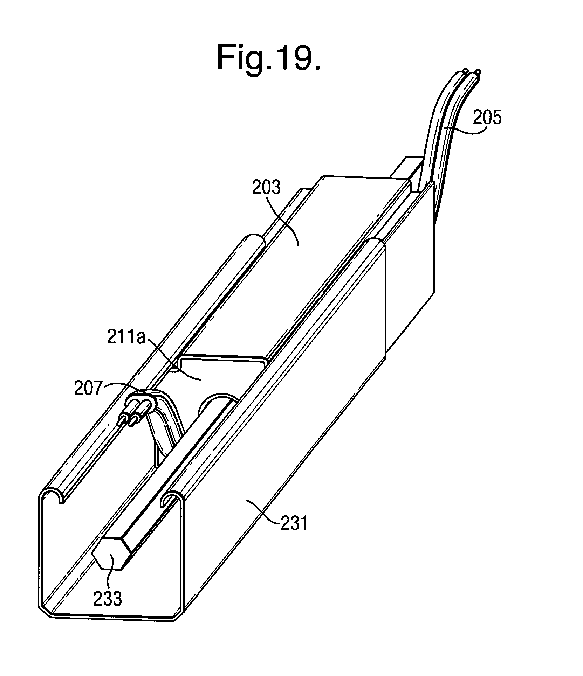

The power conversion unit 201 may be slidingly inserted into the headrail 231 as illustrated in Figure 19. Indeed, in the illustrated embodiment, the outer profile of the housing 203 is arranged to fit an inner profile of the headrail 231 such that the power conversion unit is secured in place.

## Claims

1. A power conversion unit for a powered movable window covering, the unit including:
power conversion circuitry having a transformer;
a snubber circuit for absorbing power from the transformer; and
a housing containing the power conversion circuitry and snubber circuit; wherein
the snubber circuit provides power absorbed from the transformer to the power conversion circuitry.

2. A power conversion unit according to claim 1 wherein the snubber circuit provides absorbed power to the primary side of the transformer.

3. A power conversion unit according to claim 1 or 2 wherein the transformer includes high frequency ferrite transformer cores.

4. A power conversion unit wherein the power conversion circuitry includes a rectifier for converting mains power to DC power and an inverter for converting the DC power to high frequency AC power for supply to the transformer.

5. A power conversion unit according to claim 4 wherein the high frequency is over 100 kHz.

6. A power conversion unit according to claim 4 or 5 wherein the inverter can invert the DC power to high frequency AC power with a fluctuating frequency.

7. A power conversion unit according to claim 6 wherein the frequency fluctuates between 250 kHz and 300 kHz.

8. A power conversion unit according to any preceding claim wherein said housing has a cross section suitable for insertion into a headrail of a window covering.

9. A power conversion unit according to claim 8 wherein said housing is elongate in a direction substantially perpendicular to said cross section.

10. A power conversion unit according to claim 9 wherein the power conversion circuitry includes first and second circuit boards extending in said elongate direction, the first circuit board supporting at least said transformer and the second circuit board supporting at least other components of the power conversion circuitry.

11. A power conversion unit according to claim 10 wherein the transformer is divided into a plurality of serially connected sub-transformers arranged along the first circuit board in an array in the elongate direction.

12. A power conversion unit according to claim 10 or 11 wherein large components, such as capacitors, are supported at one or both ends of one or both of the first and second circuit boards and extend generally in the elongate direction.

13. A power conversion unit according to claim 10, 11 or 12 wherein the first and second circuit boards are joined end to end so as to form a single elongate circuit board.

14. A power conversion unit according to claim 13 for use with a headrail having a rotatable shaft extending along the headrail at a generally central position, the housing having a cross section suitable for insertion into the headrail on generally one side of the rotatable shaft.

15. A power conversion unit according to claim 10, 11 or 12 wherein the first and second circuit boards extend in generally parallel spaced apart planes so as to define at least a central space therebetween.

16. A power conversion unit according to claim 15 for use with a headrail having a rotatable shaft extending along the headrail at a generally central position, the housing having openings at each end in line with the central space such that the housing can be inserted in the headrail with the rotatable shaft extending through the central space.

17. A power conversion unit according to claim 16 wherein the housing includes end caps at each end, the end caps defining said openings.

18. A power conversion unit according to claim 16 or 17 wherein the housing includes an inner wall defining an elongate central passageway extending through the housing in the central space, the passageway allowing the shaft to be located extending through the housing.

19. A headrail for a window covering including the power conversion unit of any preceding claim.

20. A headrail according to claim 19 including a rotatable shaft extending generally centrally along the length of the headrail.

21. A window covering assembly including the headrail of claim 19 or 20.

22. A method of providing power to a powered movable window covering using conversion circuitry with a transformer to obtain relatively low voltage supply from mains supply, the method including:
providing in the conversion circuitry a snubber circuit for the transformer, the snubber circuit absorbing power from the transformer and supplying power absorbed from the transformer back to the conversion circuitry such that heat generation from the conversion circuitry with the transformer is minimised; and
mounting the conversion circuitry in the headrail of the window covering so as to reduce the overall size of the window covering.

23. A method according to claim 22 further including:
supplying the transformer with high frequency AC power and using high frequency ferrite cores in the transformer.

24. A method according to claim 23 further including fluctuating the frequency of the high frequency AC power.
